# EUROPEAN PATENT APPLICATION

(11) **EP 4 491 760 A2**
(43) Date of publication of application: **15.01.2025**
(21) Application number: 24181445.8
(22) Date of filing: 11.06.2024
(51) Int. Cl.: C23C 16/46, C23C 16/48, H01L 21/67, C23C 16/458, F27B 17/00, F27D 99/00, H01L 21/673

(54) **VERTICAL FURNACE FOR PROCESSING A PLURALITY OF SUBSTRATES AND METHOD OF PROCESSING**

(30) Priority: 14.06.2023 US 202363508168 P
(71) Applicant: ASM IP Holding B.V., 1322 AP Almere (NL)
(72) Inventor: PARUI, Subir, 1322 AP Almere (NL); HOUBEN, Kelly, 1322 AP Almere (NL); OOSTERLAKEN, Theodorus G.M., 1322 AP Almere (NL); TERHORST, Herbert, 1322 AP Almere (NL); JONGBLOED, Bert, 1322 AP Almere (NL)
(74) Representative: V.O.

(57) **Abstract**

A vertical furnace and a method for processing a plurality of substrates in said vertical furnace is disclosed. Embodiments of the presently described vertical furnace comprise an process chamber, a heating element configured to provide the heat to reach the desired process temperature for the processing of the plurality of substrates. The vertical furnace may further comprise heat distributing member for distributing the heat provided by the heating element. Embodiments of the presently described method comprise processing the plurality of substrates in a vertical furnace described herein.

## Description

### FIELD OF INVENTION

The present disclosure relates to a vertical furnace for processing a plurality of substrates and a method for processing. More specifically, it relates to a vertical furnace provided with a heat distributing member.

### BACKGROUND OF THE DISCLOSURE

Processing a plurality of substrates by means of batch processing may become more and more demanding in semiconductor manufacturing as semiconductor device dimensions keep on shrinking. This not only helps to improve the process throughput but may also be advantageous for reducing process cycle time.

Vertical furnaces are, in that respect, batch processing tools that can carry out processes, such as for example, deposition, annealing, oxidation and diffusion.

Some of the challenges associated with batch processing in a vertical furnace may relate to enabling balanced heat distribution inside the process chamber. This may further influence temperature distribution inside the process chamber during processing. This may not only play a role in reaction kinetics but may also have an impact on thickness non-uniformity across the surface of the substrates positioned inside the process chamber for processing, which are arranged vertically in the substrate carrier. Issues arising from thickness non-uniformity may further have an impact on subsequent processes during semiconductor manufacturing and may eventually influence device performance.

There may, therefore, be a need for improving processing in a vertical furnace.

### SUMMARY OF THE DISCLOSURE

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter

It may be an object of the present disclosure to improve processing in a vertical furnace. More specifically, it may be an object to provide improved heat distribution in the process chamber of a vertical furnace. To at least partially achieve these objects, the present disclosure may provide a vertical furnace and a method of processing a plurality of substrates as defined in independent claims. Further embodiments are provided in the dependent claims.

In a first aspect, the present disclosure relates to a vertical furnace. The vertical furnace may be suitable for processing a plurality of substrates. The vertical furnace may comprise an inner reaction tube extending in a longitudinal direction. The inner reaction tube may be constructed and arranged to receive a plurality of substrates that may be arranged in a substrate carrier. The substrate carrier may be provided with a top plate. The vertical furnace may further comprise an outer reaction tube. The outer reaction tube may be constructed and arranged around the inner reaction tube along the longitudinal direction. The vertical furnace ma further comprise a heating element that may be constructed and arranged around the outer reaction tube along the longitudinal direction. The vertical furnace may further comprise a heat distributing member. The heat distributing member may be constructed and arranged to face the top plate of the substrate carrier. The heat distributing member may at least partially overlap with the top plate when the substrate carrier is received in the inner reaction tube to distribute the heat provided by the heating element towards a central portion of the substrate.

The vertical furnace according to embodiments of the first aspect of the present disclosure may advantageously allow for improving heat distribution in the reaction tube thanks to the presence of the heat distributing element.

It may further be an advantage that heat distribution inside the inner reaction tube, where the plurality of substrates are received for processing, may be improved, particularly for those substrates positioned in an upper portion of the substrate carrier, such as for example, those closer to the top plate of the substrate carrier.

It may further be an advantage according to embodiments of the first aspect of the present disclosure that wafer within non-uniformity of the substrates, particularly for those that are positioned on an upper portion of the substrate carrier may be reduced.

It may also be an advantage that process yield for subsequent processes that may follow the processing in the vertical furnace, may be improved thanks to the improvement in wafer within non-uniformity.

It may further be an advantage according to embodiments of the first aspect of the present disclosure that process qualification may be improved.

In a second aspect, the present disclosure relates to a vertical furnace. The vertical furnace may be suitable for processing a plurality of substrates. The vertical furnace may comprise a substrate carrier. The substrate carrier may be constructed and arranged to hold a plurality of substrates. The vertical furnace may further comprise an inner reaction tube extending in a longitudinal direction. The inner reaction tube may be constructed and arranged to receive the substrate carrier. The substrate carrier may be provided with a top plate. The vertical furnace may further comprise an outer reaction tube. The outer reaction tube may be constructed and arranged around the inner reaction tube along the longitudinal direction. The substrate carrier may comprise a heat distributing member. The heat distributing member may be provided to the top plate.

The vertical furnace according to embodiments of the second aspect of the present disclosure may provide for improved process performance due to the improved heat distribution thanks to the presence of the heat distributing element comprised in the substrate carrier.

It may further be an advantage that heat distribution inside the inner reaction tube, where the plurality of substrates are received for processing, may be improved, particularly for those substrates positioned in an upper portion of the substrate carrier, such as for example, those closer to the top plate of the substrate carrier.

It may further be an advantage according to embodiments of the first aspect of the present disclosure that wafer within non-uniformity of the substrates, particularly for those that are positioned on an upper portion of the substrate carrier may be reduced.

It may also be an advantage that process yield for subsequent processes that may follow the processing in the vertical furnace, may be improved thanks to the improvement in wafer within non-uniformity

It may further be an advantage according to embodiments of the first aspect of the present disclosure that process qualification may be improved.

In a third aspect, the present disclosure relates to a method of processing a plurality of substrates. The method may comprise providing a plurality of substrates in an inner reaction tube of a vertical furnace according to embodiments of the first aspect or the second aspect of the present disclosure. The plurality of substrates may be arranged in a substrate carrier. The method may further comprise providing a reaction gas mixture to the inner reaction tube, thereby forming a substrate film on each substrate of the plurality of substrates and an inner reaction tube film on one or more surfaces of the inner reaction tube.

The method according to embodiments of the third aspect of the present disclosure may allow for processing a plurality of substrates, whereby improved heat distribution inside the process chamber; i.e. inner reaction tube, may be achieved.

It may further be an advantage of embodiments of the third aspect of the present disclosure that processing a plurality of substrates with reduced wafer within non-uniformity may be enabled.

It may also be an advantage that process qualification may consequently be improved thanks to the improved heat distribution in the process chamber during the processing.

### BRIEF DESCRIPTION OF THE DRAWING FIGURES

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure

Like reference numbers will be used for like elements in the drawings unless stated otherwise. Reference signs in the claims shall not be understood as limiting the scope.
Fig. 1 and Fig. 2a to Fig. 2c : Schematic representation of a vertical furnace according to embodiments of the first aspect of the present disclosure.
Fig. 3a to Fig. 3h and Fig. 4a to Fig. 4b : Schematic representation of a vertical furnace according to embodiments of the second aspect of the present disclosure.
Fig. 5 : Flowchart showing an exemplary method according to embodiments of the third aspect of the present disclosure.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below

As used herein, the term "substrate" may refer to any underlying material or materials, including any underlying material or materials that may be modified, or upon which, a device, a circuit, or a film may be formed. The "substrate" may be continuous or non-continuous; rigid or flexible; solid or porous; and combinations thereof. The substrate may be in any form, such as a powder, a plate, or a workpiece. Substrates in the form of a plate may include wafers in various shapes and sizes. Substrates may be made from semiconductor materials, including, for example, silicon, silicon germanium, silicon oxide, gallium arsenide, gallium nitride and silicon carbide.

As examples, a substrate in the form of a powder may have applications for pharmaceutical manufacturing. A porous substrate may comprise polymers. Examples of workpieces may include medical devices (for example, stents and syringes), jewelry, tooling devices, components for battery manufacturing (for example, anodes, cathodes, or separators) or components of photovoltaic cells, etc.

A continuous substrate may extend beyond the bounds of a process chamber where a deposition process occurs. In some processes, the continuous substrate may move through the process chamber such that the process continues until the end of the substrate is reached. A continuous substrate may be supplied from a continuous substrate feeding system to allow for manufacture and output of the continuous substrate in any appropriate form.

Non-limiting examples of a continuous substrate may include a sheet, a non-woven film, a roll, a foil, a web, a flexible material, a bundle of continuous filaments or fibers (for example, ceramic fibers or polymer fibers). Continuous substrates may also comprise carriers or sheets upon which non-continuous substrates are mounted.

The illustrations presented herein are not meant to be actual views of any particular material, structure, or device, but are merely idealized representations that are used to describe embodiments of the disclosure.

The particular implementations shown and described are illustrative of the invention and its best mode and are not intended to otherwise limit the scope of the aspects and implementations in any way. Indeed, for the sake of brevity, conventional manufacturing, connection, preparation, and other functional aspects of the system may not be described in detail. Furthermore, the connecting lines shown in the various figures are intended to represent exemplary functional relationships and/or physical couplings between the various elements. Many alternative or additional functional relationship or physical connections may be present in the practical system, and/or may be absent in some embodiments.

It is to be understood that the configurations and/or approaches described herein are exemplary in nature, and that these specific embodiments or examples are not to be considered in a limiting sense, because numerous variations are possible. The specific routines or methods described herein may represent one or more of any number of processing strategies. Thus, the various acts illustrated may be performed in the sequence illustrated, in other sequences, or omitted in some cases.

The subject matter of the present disclosure includes all novel and nonobvious combinations and sub-combinations of the various processes, systems, and configurations, and other features, functions, acts, and/or properties disclosed herein, as well as any and all equivalents thereof.

It is to be noticed that the term "comprising", as used herein, should not be interpreted as being restricted to the means listed thereafter. It does not exclude other elements or steps. It is thus, to be interpreted as specifying the presence of the stated features, steps or components as referred to. However, it does not prevent one or more other steps, components, or features, or groups thereof from being present or being added.

Reference throughout the specification to "embodiments" in various places are not necessarily all referring to the same embodiment, but may. Furthermore, the particular features, structures or characteristics maybe combined in any suitable manner, as would be apparent to one of the ordinary skill in the art from the disclosure, in one or more embodiments.

Reference throughout the specification to "some embodiments" means that a particular structure, feature step described in connection with these embodiments is included in some of the embodiments of the present invention. Thus, phrases appearing such as "in some embodiments" in different places throughout the specification are not necessarily referring to the same collection of embodiments, but may.

Reference throughout this specification to "one embodiment" or "an embodiment" means that a particular feature, structure, or characteristic described in connection with the embodiment is included in at least one embodiment of the present disclosure. Thus, appearances of the phrases "in one embodiment" or "in an embodiment" in various places throughout this specification are not necessarily all referring to the same embodiment, but may.

It is to be noticed that the term "comprise substantially" used in the claims refers that further components than those specifically mentioned can, but not necessarily have to, be present, namely those not materially affecting the essential characteristics of the material, compound, or composition referred to.

The terms first, second, third, and the like in the description and in the claims, are used for distinguishing between similar elements. They are not necessarily used for describing a sequence, either temporally, spatially, in ranking, or in any other manner. It is to be understood that the terms so used are interchangeable under appropriate circumstances and that the embodiments of the disclosure described herein are capable of operation in other sequences than described or illustrated herein.

The following terms are provided only to help in the understanding of the disclosure.

As used herein and unless provided otherwise, the term "*central portion of the substrate*" may refer to a portion of the substrate in close proximity to its center.

As used herein and unless provided otherwise, the term "*wafer within non-uniformity (WIWNU)*" may refer to the variation in layer thickness across the surface of the substrates.

As used herein and unless provided otherwise, the term "*process qualification*" may refer to implementing the required remedies to have the process reach its dedicated process performance at a given processing system.

The disclosure will now be described by a detailed description of several embodiments of the disclosure. It is clear that other embodiments of the disclosure can be configured according to the knowledge of persons skilled in the art in the absence of departure from the technical teaching of the disclosure. The disclosure is limited only by the terms of the claims included herein.

Herein described is a vertical furnace according to embodiments of the first aspect of the present disclosure.

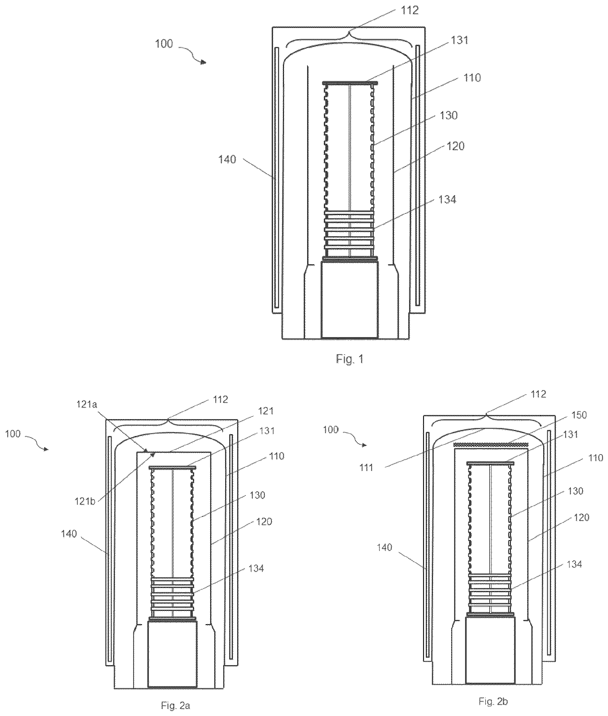

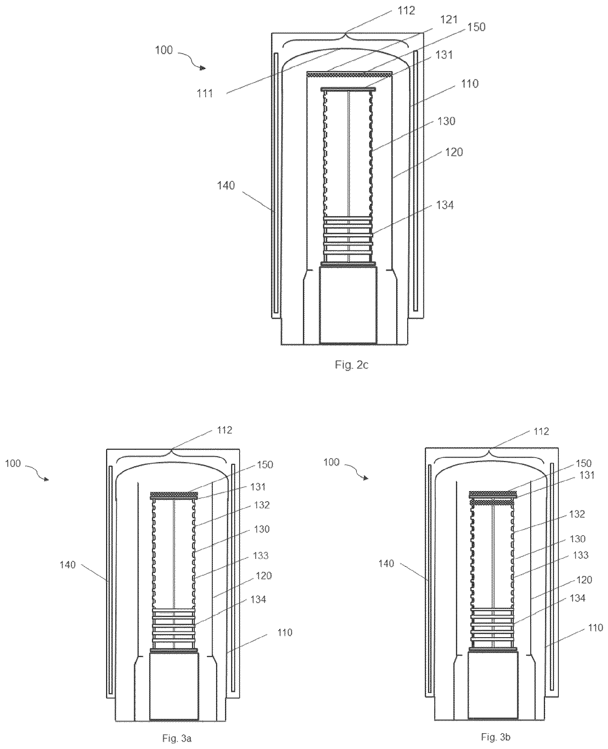

Fig. 1 and Fig. 2 shows a representation of this vertical furnace.

The vertical furnace (100) may be suitable for processing a plurality of substrates. The vertical furnace (100) may comprise an inner reaction tube (120). The inner reaction tube (120) may extend in a longitudinal direction. The longitudinal direction may be a vertical direction, as schematically shown on Fig. 1, with respect to the ground on which the vertical furnace is positioned.

The inner reaction tube (120) may be constructed and arranged to receive the plurality of substrates (134). The plurality of substrates may be provided to the inner reaction tube (120) from an opening at its lower end. The plurality of substrates may be arranged in a substrate carrier (130). The substrate carrier (130) may be provided with a top plate (131).

The vertical furnace (100) may further comprise an outer reaction tube (110). The outer reaction tube may be constructed and arranged around the inner reaction tube (120) along the longitudinal direction. In other words, the outer reaction tube may also extend along the vertical direction. In embodiments, the inner reaction tube (120) and the outer reaction tube (110) may be positioned substantially concentric with respect to one another.

The vertical furnace (100) may also comprise a heating element (140). The heating element may be constructed and arranged around the outer reaction tube (110) along the longitudinal direction. The heating element (140) may provide the heat to reach the desired process temperature for the processing of the plurality of substrates.

In some embodiments, the heating element (140) may be a cylindrical heating element. In other words, the heating element may be surrounding the outer reaction tube (110) around its side walls along the longitudinal direction. This may thus, leave the upper portion of the outer reaction tube (110) absent from being surrounded by the heating element.

The vertical furnace (100) may further comprise a heat distributing member (150). The heat distributing member may be constructed and arranged to face the top plate (131) of the substrate carrier (130). The heat distributing member (150) may at least partially overlap with the top plate (131) when the substrate carrier is received in the inner reaction tube (120) to distribute the heat provided by the heating element (140) towards a central portion of the substrate (134).

The heating element (140) may thus, extend along the longitudinal direction substantially to the same height as that of the outer reaction tube (110). When the substrate carrier (130) is thus, received in the inner reaction tube (120) for processing the plurality of substrates (134), the heating element (140) may provide heat substantially to all of the substrates (134) that may be arranged in the substrate carrier (130).

The vertical furnace (100) may advantageously allow for improving heat distribution in the inner reaction tube (120) thanks to the presence of the heat distributing element. Improved heat distribution may improve temperature driven phenomena occurring on the surface of the substrates, such as for example, oxidation, diffusion, deposition. Improved heat distribution may further improve such as for example thermal anneal process.

Furthermore, improved heat distribution may advantageously lead to reducing wafer within non-uniformity. In this respect, the advantage may be obtained particularly for substrates that are located on upper slots of the substrate carrier (130).

Upper slots of the substrate carrier may be those that are closer to the inner surface (111) of the outer reaction tube (110) when the substrate carrier (130) is positioned inside the inner reaction tube (120). The advantage gained may be due to the fact that the heat loss, which may typically be higher in an upper portion of the inner reaction tube (120) than its center, is reduced.

Without wishing to be bound by theory, it may be stated that this may originate due to the absence of a top heater in the vertical furnace (100). While the substrates located in the central slots of the substrate carrier may be exposed to uniform heat distribution thanks to the presence of the substrates still above and below the central portion of the substrate carrier, those located in the upper slots, may thus, suffer from reduced heat distribution due to the absence of the top heater. Therefore, discrepancies in terms of heat distribution between the substrates located at upper slots compared to central slots of the substrate carrier may result in an increased wafer within non-uniformity for the substrates located at upper slots.

Improving wafer within non-uniformity may further have an impact on the process yield of the subsequent processes. Having variations of layer thickness on the surface of a substrate may pose challenges on subsequent processes such as for example, further deposition process, patterning including lithography and etching. This may lead to scrapping some of the substrates due to the decrease in yield of such subsequent processes. Therefore, improving wafer within non-uniformity may be advantageous to reduce the risk of jeopardizing yield of such subsequent processes.

It may, thus, be a further advantage that process qualification may be improved such that a targeted substrate load size in a substrate carrier may be processed with substantially the same wafer within non-uniformity values for all the substrates held therein.

In some embodiments, the inner reaction tube (120) may be delimited by a closed top end (121). as may be schematically shown in Fig. 2a.

When the substrate carrier (130) is thus, received inside the inner reaction tube (120), the top plate (131) of the substrate carrier (130) faces the lower surface (121b) of the closed top end (121). An upper surface (121a) of the closed top end (121) is positioned opposite to the lower surface (121b) of the closed top end (121).

The heat distributing element (150) may be provided to the closed top end (121) in these embodiments. This may allow for enhancing heat distribution from the heating element (140) to the central portion of the substrate (134). This may particularly be advantageous for substrates that are located on upper slots of the substrate carrier (130). The presence of the heat distributing member (150) may advantageously help the heat provided by the heating element (140) through the side walls of the outer reaction tube (110), which is further transferred to the inner reaction tube (120), to be re-distributed towards the central portion of these substrates.

In embodiments, the heat distributing member (150) may be provided to a surface part of the closed top end (121). The closed top end (121) may have an upper surface (121a). The upper surface (121a) may face the inner surface (111) of the outer reaction tube (110). The closed top end (121) may further have a lower surface (121b) that faces away from the inner surface (111) of the outer reaction tube (110) and that is opposite to the upper surface (121a) of the closed top end (121).

In embodiments, the heat distributing member (150) may be in the form of a plate, a disc or alike that may allow easy provision to the surface of the closed top end (121).

In some embodiments, the surface part of the closed top end (121) where the heating element is provided may thus, be the upper surface (121a) of the closed top end (121) as may be schematically represented in Fig. 2b.

In embodiments, the heat distributing member (150) may be constructed and arranged to be receivable on the upper surface (121a) of the closed top end (121).

This may provide the advantage of an easy provision of the heat distributing member (150) to the closed top end (121) as the heat distributing member (150) may be positioned there thanks to the presence of gravitational force.

In some embodiments, the heat distributing member (150) may be provided to the upper surface (121a) of the closed top end (121) by connecting means such as for example, bolts, screws or cords allowing for a more robust and reliable provision.

In some embodiments, the heat distributing member (150) may be provided to the lower surface (121b) of the closed top end (121) as may be schematically shown in Fig. 2c. In other words, the upper surface (121a) of the closed top end (120), may remain exposed in these embodiments.

In embodiments, the heat distributing member (150) may be provided to the lower surface (121b) of the closed top end (121) by connecting means such as for example, bolts, screws or cords.

In embodiments, the heat distributing member (150) may overlap at least partially with the with the surface (121a; 121b) of the closed top end (121) onto which it is provided, in terms of its surface area.

In some embodiments, the heat distributing member (150) may at least overlap with the surface area of the top plate (131) of the substrate carrier (130), when the substrate carrier is received in the inner reaction tube.

In some embodiments, the heat distributing member (150) may substantially overlap with the surface of the closed top end (121) onto which it is provided. In other words, the surface area of the heat distributing element may substantially be the same as that of the surface area of the closed top end (121) onto which it is provided.

In embodiments, the thickness of the heat distributing member may be in a range of 2 mm to 35 mm. In some embodiments, the thickness of the heat distributing member may be may be in a range of 5 mm to 25 mm. In some embodiments, the thickness may be in a range of from at least 5 mm to at most 10 mm, or from at least 10 mm to at most 15 mm, or from at least 15 mm to at most 20 mm, or from at least 20 mm to at most 25 mm, or from at least 25 mm to at most 30 mm, or from at least 30 mm to at most 35 mm.

In embodiments, the surface of the heat distributing member (150) may have roughness. When roughness is present on a surface of the heat distributing member which may get into contact with the upper surface (121a) of the closed top end (121) of the inner reaction tube (120), it may advantageously allow for enhancing grip with the upper surface (121a) of the closed top end (121), thus avoiding slip and thereby, providing improved stability for the heat distributing member (150).

When the roughness is present on a surface of the heat distributing member being opposite to the surface that may get into contact with the lower surface (121b) of the closed top end (121) of the inner reaction tube (120), film deposition may also occur on this rough surface. The rough surface may accommodate for more deposition material adhering to this rough surface, thereby allowing for a thicker film deposition. The thicker film deposition on the rough surface may advantageously make the film deposited thereon to have increased resistance towards stress release. This may help to reduce particle formation inside the inner reaction tube (120). Reduced particle formation may advantageously allow for improving the yield f the process carried out in the vertical furnace (100).

In embodiments, the vertical furnace may further comprise a gas injector constructed and arranged to provide a precursor gas or a process gas to the inner reaction tube (120). The gas injector may be a multi-hole gas injector comprising multiple gas outlets along its longitudinal dimension.

In embodiments, the inner reaction tube (120) with the closed top end (121) may be constructed and arranged to enable cross-flow, or in other words, horizontal flow of the process gas inside the inner reaction tube (120). This may be provided thanks to the exhaust gas openings or slits that may correspond horizontally to each of the multiple gas outlets comprised in the multi-hole gas injector. This may then be advantage to allow for having a flow of the precursor gas or the process gas parallel to the surface of each of the substrates arranged in the substrate carrier.

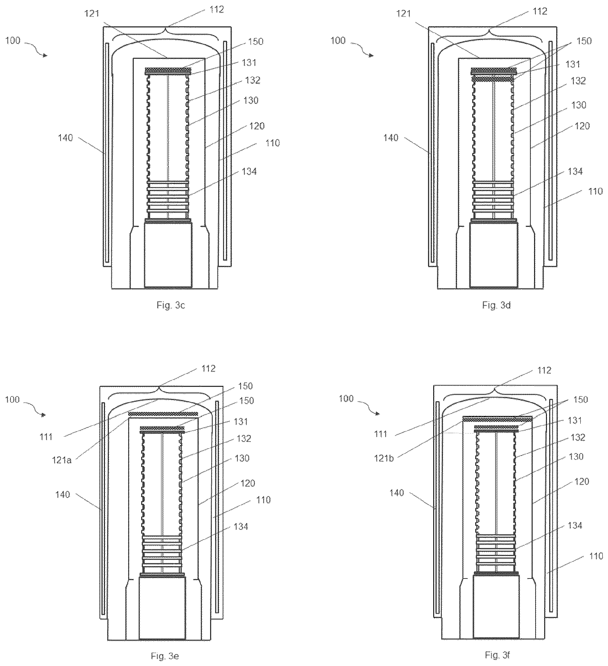

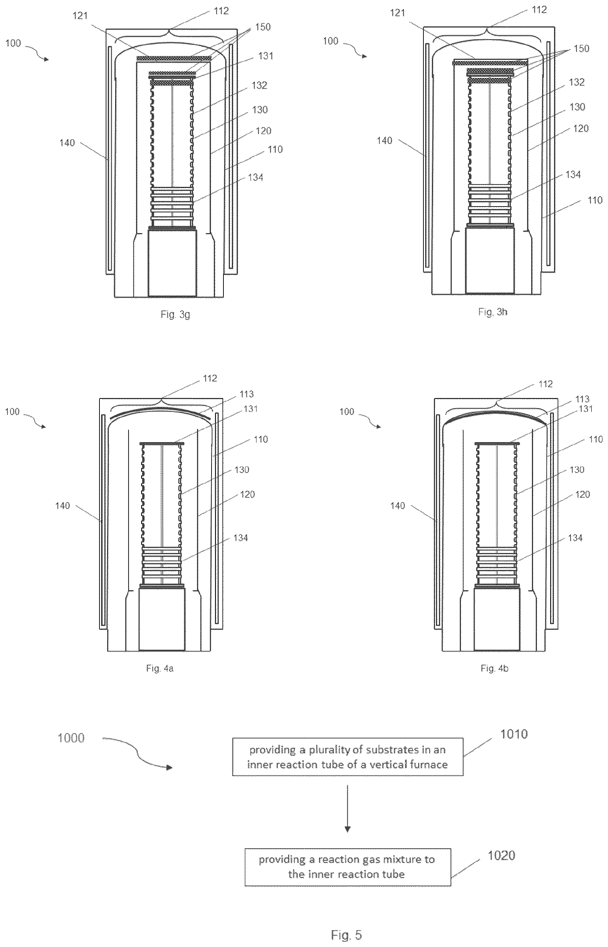

Further described herein is a vertical furnace according to the second aspect of the present disclosure. Fig. 3 shows a schematic representation of a vertical furnace according to embodiments of the second aspect of the present disclosure.

The vertical furnace may be suitable for processing a plurality of substrates. The vertical furnace (100) may be suitable for processing a plurality of substrates. The vertical furnace (100) may comprise an inner reaction tube (120). The inner reaction tube (120) may extend in a longitudinal direction. The longitudinal direction may be a vertical direction, as schematically shown on Fig. 3a, with respect to the ground on which the vertical furnace (100) is positioned.

The vertical furnace (100) may comprise a substrate carrier (130). The substrate carrier may be constructed and arranged to hold a plurality of substrates (134).

The inner reaction tube (120) may be constructed and arranged to receive the substrate carrier (130). The plurality of substrates may be provided to the inner reaction tube (120) from an opening at its lower end. The plurality of substrates may be arranged in a substrate carrier (130). The substrate carrier (130) may be provided with a top plate (131).

The vertical furnace (100) may further comprise an outer reaction tube (110). The outer reaction tube may be constructed and arranged around the inner reaction tube (120) along the longitudinal direction. In other words, the outer reaction tube (110) may also extend along the vertical direction. The vertical furnace (100) may further comprise a heating element (140). The heating element (140) may be constructed and arranged around the outer reaction tube (110) along the longitudinal direction. The substrate carrier (130) may comprise a heat distributing member (150). The heat distributing member (150) may be provided to the top plate (131).

In some embodiments, the heating element (140) may be a cylindrical heating element. In other words, the heating element may be surrounding the outer reaction tube (110) around its side walls along the longitudinal direction. This may thus, leave the upper portion of the outer reaction tube (110) absent from being surrounded by the heating element.

In embodiments, the inner reaction tube (120) and the outer reaction tube (110) may be positioned substantially concentric with respect to one another.

In embodiments, the heat distributing member (150) may overlap at least partially with the with the top plate (131) in terms of its surface area when provided to the top plate (131).

In some embodiments, the heat distributing member (150) may have substantially the same surface area as that of the the top plate (131).

The vertical furnace (100) may also be advantageous in improving the heat distribution thanks to the presence of the heat distributing element (150) provided to the top plate (131). The heat loss that may occur through the upper portion of the inner reaction tube (120) may be reduced. This heat loss may be occurring due to the absence of a top heater in the vertical furnace (100). The presence of the heat distributing member (150) may thus, help to supply the heat towards the central portion of the substrates (134). This may particularly be advantageous for the substrates (134) that are positioned in the upper slots (132) of the substrate carrier, such as for example, those slots that are positioned closer to the top plate (131). Upper slots of the substrate carrier (130) may be those that are thus, closer to the inner surface (111) of the outer reaction tube (110) when the substrate carrier (130) is positioned inside the inner reaction tube (120).

While the substrates located in the central slots (132) of the substrate carrier may be exposed to uniform heat distribution thanks to the presence of the substrates still above and below the central portion of the substrate carrier, those located in the upper slots, may thus, suffer from reduced heat distribution due to the absence of the top heater. Therefore, discrepancies in terms of heat distribution between the substrates located at upper slots compared to central slots of the substrate carrier may result in an increased wafer within non-uniformity for the substrates located at upper slots.

Improved heat distribution across the surface of the substrate may advantageously lead to reducing wafer within non-uniformity. This may then be particularly advantageous for the substrates (134) that are positioned in the upper slots of the substrate carrier.

It may thus, be an advantage according to embodiments of the first aspect of the present disclosure that process qualification may be improved such that a targeted substrate load size in a substrate carrier may be processed with substantially the same wafer within non-uniformity values for all the substrates held therein.

In embodiments, the heat distributing member (150) may be releasably attached to the top plate (131). This may be advantageous for providing ease of handling the heat distributing element (150) in case of maintenance and/or replacement.

In embodiments, the substrate carrier (130) may comprise at least two rods (133). The at least two rods may extend from a bottom plate of the substrate carrier (130) to the top plate (131) and connecting the bottom plate thereto. In some embodiments, the substrate carrier may comprise three rods, two of which may be referred to as side rods. Each of the at least two rods (133) may comprise a plurality of slots (132). The substrate carrier (130) may comprise a further heat distributing member (150). The further heat distributing member may be provided to the top most slot (132) of the substrate carrier (130) as may be schematically represented in Fig. 3b.

This may provide the advantage of enhancing the heat distribution over the substrate carrier. This may particularly be advantageous in providing an enhanced heat distribution for the substrates located in an upper portion of the substrate carrier.

In some embodiments, a further heat distributing member may be provided to the lower most slot of the substrate carrier (130) (not shown in the figures). This may provide heat distribution to the substrates located in the lower portion of the substrate carrier (130). In embodiments, this further heat distributing member to be placed in the lower portion of the substrate carrier may be substantially the same or may be different from the heat distributing member to be placed in the upper portion of the substrate carrier.

The presence of the heat distributing member in the upper or in the lower portion of the substrate carrier may be advantageous such that it may be easily removed from the substrate carrier (130) when performing preventive maintenance.

In embodiments, the inner reaction tube (120) may be delimited by an open top end as may be schematically represented in Fig. 3a or by a closed top end (121) as may be schematically represented in Fig. 3c. Thus, the presence of the heat distributing member (150) provided to the top plate (131) of the substrate carrier (130) may provide a more efficient distribution of the heat towards the center of the substrates, particularly those held in the upper slots (132). This may be particularly advantageous when the inner reaction tube is limited by the closed top end (Fig. 3c). This may be due to the creation a closed space volume above the substrate carrier (130) thanks to the closed top end such that the heat transferred by the heating element (140) may be captured and may be re-directed in a more efficient way.

In embodiments, the inner reaction tube (120) with the closed top end (121) may be constructed and arranged to enable cross-flow, or in other words, horizontal flow of the process gas inside the inner reaction tube (120). This may be provided thanks to the exhaust gas openings or slits that may correspond horizontally to each of the multiple gas outlets comprised in the multi-hole gas injector. This may then be advantage to allow for having a flow of the precursor gas or the process gas parallel to the surface of each of the substrates arranged in the substrate carrier.

In some embodiments, as may be represented schematically in Fig. 3d, the substrate carrier (130) having the heat distributing member (150) provided both on its top plate (131) and on its top most slot (132) may be received in the inner reaction tube (120) delimited with the closed top end (131). This kind of configuration may enhance heat distribution further. This may thus allow for a more efficient reduction in the WIWNU of the substrates particularly positioned in the upper slots (132) of the substrate carrier (130).

In some embodiments, the heat distributing member (150) may further be comprised in the closed top end (120) of the inner reaction tube. The heat distributing member (150) may be provided to a surface part of the closed top end (120) as may be schematically represented in Fig. 3e, Fig. 3f, Fig. 3g, Fig, 3h.

In some embodiments, the surface part of the closed top end (120), to which the heat distributing member (150) is provided may be an upper surface (121a) of the closed top end (121) as may be schematically represented in Fig. 3e and Fig. 3g. The upper surface (121a) of the closed top end (120) may thus, face an inner surface (111) of the outer reaction tune (110). The inner surface (111) of the outer reaction tube (110) facing the upper surface (121a) of the inner reaction tube (120) may thus, be an upper inner surface of the outer reaction tube (110). The upper inner surface (111) may be located in an upper part of the outer reaction tube and facing the ground on which the vertical furnace is positioned. As seen in these embodiments, the substrate carrier (130) may have the heat distributing element (150) provided to its top plate (131).

In some embodiments, the surface part of the closed top end (120), to which the heat distributing member is provided may be a lower surface (121b) of the closed top end (121). The lower surface (121b) of the closed top end (120) may thus, face an upper surface of the heat distributing member (150) that may be provided to the top plate (131) of the substrate carrier (130) as may be schematically represented in Fig. 3f and Fig. 3h. As seen in these embodiments, the substrate carrier (130) may have the heat distributing element (150) provided to its top plate (131) and also on its top most slot (132).

In embodiments, the heat distributing element (150) may be comprised of a thermally conducting material. The thermally conducting material may provide the advantage of collecting and then re-distributing the heat emanating from the heating element (140) towards the inner reaction tube (120), particularly in an upper portion of the inner reaction tube, where there may be the absence of a top heater provided therein.

In embodiments, the thermally conducting material may comprise silicon.

In some embodiments, the thermally conducting material may comprise substantially at least one of silicon and silicon carbide. Such a heat distributing member (150) may be advantageous such that it will not pose any mismatch with respect to the thermal conductivity of the substrate carrier (130) when the substrate carrier is made of a Si comprising material such as for example, silicon carbide. Furthermore, such a heat distributing member (150) may also be advantageous when coupled with a substrate carrier made of quartz. Quartz substrate boats may be preferable over silicon carbide substrate carriers due to them being more economical. Presence of a heat distributing element (150), as disclosed herein, may therefore, provide an efficient means of heat distribution inside the inner reaction tube (120), while also providing an economic advantage.

In embodiments, the outer reaction tube (110) may be delimited by a dome-shaped top end (112) as may be schematically represented in Fig. 1. The dome-shaped top end (112) may comprise a coating (113). This coating (113) may, in embodiments, be a reflective coating. The heat loss towards the top of the outer reaction tube (110) may become pronounced in the absence of a top heater. Thus, the reflective coating may provide the advantage of reducing heat loss from the dome-shaped top end (112) during processing of the plurality of substrates (134).

In embodiments, the reflective coating may be such as a high temperature resistant paint that may be applied directly on the dome-shaped top end (112).

In embodiments, the reflective coating (113) may comprise silicon.

In some embodiments, the reflective coating may comprise substantially silicon.

It may be advantageous to combine the silicon comprising reflective coating (113) with a quartz outer reaction tube (110). This may reduce the risk of having thermal mismatch between the reflective coating (113) and the outer reaction tube (110).

In some embodiments, the coating (113) may be comprised on an inner surface (111) of the dome-shaped tope end that faces the top plate (131) of the substrate carrier as may be schematically represented in Fig. 4b.

In some embodiments, the coating (113) may be comprised on an outer surface of the dome-shaped tope end (112) , the outer surface being opposite to the inner surface (111) of the dome-shaped top end as may be schematically represented in Fig. 4a. This may be advantageous when performing an in-situ clean process to clean one or more inner surfaces of the outer reaction tube (110). One or more inner surfaces of the outer reaction tube (110) may also get coated as a result of processing in the vertical furnace (100), particularly when the inner reaction tube (120) is delimited by an open top end. Therefore, by having the coating on an outer surface of the dome-shaped top end (112) may advantageously prevent the coating from getting removed during in-situ clean process.

Further described herein is a method of processing a plurality of substrates according to the third aspect of the present disclosure. Fig. 5 may represent a flowchart showing an exemplary method according to embodiments of the third aspect of the present disclosure.

The method (1000) may comprise providing a plurality of substrates (1010) in an inner reaction tube (120) of a vertical furnace according to the first aspect or the second aspect of the present disclosure. The plurality of substrates (134) may be arranged in a substrate carrier (130).

The method (1000) may further comprise providing (1020) a reaction gas mixture to the inner reaction tube (120). This may lead to the formation of a substrate film on each substrate of the plurality of substrates (134) and an inner reaction tube film on one or more surfaces of the inner reaction tube (120).

In embodiments, the substrate film and the inner reaction tube film may comprise an oxide or a nitride.

The presence of the inner reaction tube film may pose risks in the long run as processing continues in the vertical furnace. The increasing layer thickness of the inner reaction tube film on the one or more surfaces of the inner reaction tube (120) may be associated with particle generation that can reduce the yield of processing. Process control may however, be implemented in order to monitor the increase in the thickness as function of lot turns and then action may be taken to clean the inner reaction tube film.

Thus, in embodiments, the method (1000) may further comprise repeating the provision of the reaction gas mixture one or more times until the inner reaction tube film thickness has reached a pre-determined thickness. When the inner reaction tube film thickness has reached the pre-determined thickness, the method may comprise exposing, in-situ, the one or more surfaces of the inner reaction tube (120) to an ambient, thereby, removing the inner reaction tube film. In other words, the inner reaction tube film may be in-situ cleaned.

The embodiments of the present disclosure do not limit the scope of invention as these embodiments are defined by the claims appended herein and their legal equivalents. Any equivalent embodiments are intended to be within the scope of this invention. Modifications of the disclosure that are different from one another, in addition to those disclosed herein, may become apparent to those skilled in the art. Such modifications and the embodiments originating therefrom, are also intended to fall within the scope of the claims appended herein.

## Claims

1. A vertical furnace for processing a plurality of substrates, comprising:
- an inner reaction tube extending in a longitudinal direction and constructed and arranged to receive a plurality of substrates arranged in a substrate carrier, the substrate carrier provided with a top plate,
- an outer reaction tube constructed and arranged around the inner reaction tube along the longitudinal direction,
- a heating element constructed and arranged around the outer reaction tube along the longitudinal direction,
wherein,
the vertical furnace further comprises a heat distributing member constructed and arranged to face the top plate of the substrate carrier and at least partially overlap with the top plate when the substrate carrier is received in the inner reaction tube to distribute the heat provided by the heating element towards a central portion of the substrate.

2. The vertical furnace according to claim 1, wherein the inner reaction tube is delimited by a closed top end and wherein the heat distributing member is provided to the closed top end.

3. The vertical furnace according to claim 2, wherein the heat distributing member is provided to a surface part of the closed top end.

4. The vertical furnace according to claim 3, wherein the surface part of the closed top end is an upper surface of the closed top end that faces an inner surface of the outer reaction tube.

5. The vertical furnace according to claim 4, wherein the heat distributing member is constructed and arranged to be receivable on the upper surface of the closed top end.

6. The vertical furnace according to claim 3, wherein the surface part of the top end is a lower surface of the closed top end that faces away from an inner surface of the outer reaction tube.

7. A vertical furnace for processing a plurality of substrates, comprising:
- a substrate carrier constructed and arranged to hold a plurality of substrates,
- an inner reaction tube extending in a longitudinal direction and constructed and arranged to receive the substrate carrier, the substrate carrier provided with a top plate,
- an outer reaction tube constructed and arranged around the inner reaction tube along the longitudinal direction,
- a heating element constructed and arranged around the outer reaction tube along the longitudinal direction,
wherein,
the substrate carrier comprises a heat distributing member provided to the top plate.

8. The vertical furnace according to claim 7, wherein the heat distributing member is releasably attached to the top plate.

9. The vertical furnace according to claim 7 or 8, wherein the substrate carrier comprises at least two rods, wherein each rod comprises a plurality of slots and wherein the substrate carrier comprises a further heat distributing member provided to the top most slot.

10. The vertical furnace according to any one of claims 7 to 9, wherein the inner reaction tube is delimited by an open top end or by a closed top end.

11. The vertical furnace according to claim 10, wherein the inner reaction tube is delimited by the closed top end and wherein the heat distributing member is further comprised in the closed top end provided to a surface part of the closed top end.

12. The vertical furnace according to claim 11, wherein the surface part of the closed top end is an upper surface of the closed top end that faces an inner surface of the outer reaction tube or the surface part of the top end is a lower surface of the closed top end that faces away from the inner surface of the outer reaction tube.

13. The vertical furnace according to any one of claims 1 to 12, wherein the heat distributing element is comprised of a thermally conducting material.

14. The vertical furnace according to claim 13, wherein the thermally conducting material comprises substantially at least one of silicon and silicon carbide.

15. The vertical furnace according to any one of claims 1 to 14, wherein the outer reaction tube is delimited by a dome-shaped top end, wherein the dome-shaped top end comprises a coating.

16. The vertical furnace according to claim 15, wherein the coating is a reflective coating, thereby reducing heat loss from the dome-shaped top end during the processing.

17. The vertical furnace according to claim 15 or 16, wherein the coating is comprised on an inner surface of the dome-shaped top end that faces the top plate or is comprised on an outer surface of the dome-shaped top end, the outer surface being opposite to the inner surface.

18. A method of processing a plurality of substrates, the method comprising:
- providing a plurality of substrates in an inner reaction tube of a vertical furnace according to any one of claims 1 to 17 and wherein the plurality of substrates is arranged in a substrate carrier,
- providing a reaction gas mixture to the inner reaction tube, thereby forming a substrate film on each substrate of the plurality of substrates and an inner reaction tube film on one or more surfaces of the inner reaction tube.

19. The method according to claim 18, wherein the method further comprises:
- repeating the provision of the reaction gas mixture one or more times until the inner reaction tube film has reached a pre-determined thickness, and;
- when the inner reaction tube film has reached the pre-determined thickness, exposing, in-situ, the one or more surfaces of the inner reaction tube to an ambient, thereby removing the inner reaction tube film.

20. The method according to claim 18 or 19, wherein the substrate film and the inner reaction tube film comprises an oxide or a nitride.
